# EUROPÄISCHE PATENTSCHRIFT

(11) **EP 2 853 027 B1**
(45) Veröffentlichungstag und Bekanntmachung des Hinweises auf die Patenterteilung: **19.02.2020**
(21) Anmeldenummer: 13725316.7
(22) Anmeldetag: 16.05.2013
(51) Int. Cl.: H03K 17/96

(54) **ANORDNUNG MIT SENSORELEMENTEINRICHTUNG AN EINEM BAUTEILTRÄGER FÜR EINEN KAPAZITIVEN BERÜHRUNGSSCHALTER EINER BEDIENEINRICHTUNG, BEDIENEINRICHTUNG UND KOCHFELD MIT EINER SOLCHEN**
ARRANGEMENT WITH SENSOR ELEMENT DEVICE ON A COMPONENT CARRIER FOR A CAPACITIVE TOUCH SWITCH OF AN OPERATING DEVICE, OPERATING DEVICE, AND COOKING HOB WITH SUCH AN ARRANGEMENT
AGENCEMENT AVEC DISPOSITIF A ELEMENT CAPTEUR SUR UN SUPPORT DE COMPOSANTS POUR UN COMMUTATEUR TACTILE CAPACITIF D'UN DISPOSITIF DE COMMANDE, DISPOSITIF DE COMMANDE ET PLAQUE DE CUISSON AVEC UN TEL AGENCEMENT

(30) Priorität: 21.05.2012 DE 102012010321
(43) Veröffentlichungstag der Anmeldung: 01.04.2015
(73) Patentinhaber: E.G.O. Elektro-Gerätebau GmbH, 75038 Oberderdingen (DE)
(72) Erfinder: KELLER, Hartmut, 76356 Weingarten (DE)
(74) Vertreter: Patentanwälte Ruff, Wilhelm, Beier, Dauster & Partner mbB
(86) Internationale Anmeldenummer: PCT/EP2013/060205
(87) Internationale Veröffentlichungsnummer: WO 2013/174728

(56) Entgegenhaltungen:
- WO-A1-2005/043760
- WO-A1-2009/153161
- DE-A1-102008 047 325
- DE-A1-102009 036 161

## Beschreibung

### Anwendungsgebiet und Stand der Technik

Die Erfindung betrifft eine Anordnung mit einer Sensorelementeinrichtung an einem Bauteilträger für einen kapazitiven Berührungsschalter einer Bedieneinrichtung, eine solche Bedieneinrichtung sowie ein Kochfeld mit einer solchen Bedieneinrichtung.

Aus der DE 10 2009 036 162 A1 ist eine Sensorelementeinrichtung für einen kapazitiven Berührungsschalter bekannt, welche eine Leuchtanzeige mit Leuchtmittel aufweist. Ein rahmenartiger Körper aus Kunststoff sitzt auf einem Ringkörper aus elastischem, elektrisch leitfähigem Kunststoff, wobei beide über eine LED als Leuchtmittel gesteckt sind. Hierbei besteht der Nachteil, dass eine Befestigung nicht punktgenau möglich ist, weil vor allem die Anbringung des elastischen Kunststoffs in Form eines Schaumgummis positionsgenau auf einer Leiterplatte nicht leicht ist.

Ähnliche Sensorelementeinrichtungen an Bauteilträgern sind aus DE 10 2008 047325 A1, WO 2005/043760 A1, WO 2009/153161 A1 sowie DE 10 2009 036161 A1 bereits bekannt.

### Aufgabe und Lösung

Der Erfindung liegt die Aufgabe zugrunde, eine eingangs genannte Anordnung mit einer Sensorelementeinrichtung, eine damit versehene Bedieneinrichtung sowie ein Kochfeld zu schaffen, mit denen Probleme des Standes der Technik vermieden werden können, und es insbesondere möglich ist, eine praxistaugliche Ausführung zu schaffen, die auch großserientechnisch präzise und zu günstigen Kosten herstellbar ist sowie möglichst auch automatisiert montiert werden kann.

Gelöst wird diese Aufgabe durch eine Anordnung mit einer Sensorelementeinrichtung an einem Bauteilträger mit den Merkmalen des Anspruchs 1, eine Bedieneinrichtung mit den Merkmalen des Anspruchs 11 sowie ein Kochfeld mit den Merkmalen des Anspruchs 13. Vorteilhafte sowie bevorzugte Ausgestaltungen der Erfindung sind Gegenstand der weiteren Ansprüche und werden im Folgenden näher erläutert.

Es ist vorgesehen, dass die Sensorelementeinrichtung eine Oberseite aufweist, die zur Unterseite eines Bedienfeldes der Bedieneinrichtung hin weist. Eventuell kann sie sogar daran angelegt sein. Des Weiteren weist die Sensorelementeinrichtung eine Leuchtanzeige mit einem Leuchtmittel auf, wobei eine Leuchtrichtung zur Unterseite des Bedienfeldes hin weist, möglichst zu dessen Durchstrahlung.

Erfindungsgemäß ist vorgesehen, dass um das Leuchtmittel herum ein Gehäuse vorgesehen ist bzw. die Sensorelementeinrichtung ein Gehäuse aufweist. Zur Befestigung der Sensorelementeinrichtung an dem Bauteilträger weist das Gehäuse Befestigungsmittel auf, wobei die beiden zusammen eine Baueinheit bilden. Unter Umständen können sie sogar einstückig ausgebildet sein, was nachfolgend näher erläutert wird.

Außen an dem Gehäuse bzw. der Baueinheit ist in dem Bereich zur Oberseite hin ein elektrisch leitfähiger Kunststoff vorgesehen, alternativ jedoch nicht zur Erfindung gehörend ein elektrisch leitfähiges metallisches Bauteil, mit einem Verlauf zumindest teilweise entlang eines Außenrandes des Gehäuses bzw. der Baueinheit. Dieser elektrisch leitfähige Kunststoff bildet das funktionale kapazitive Sensorelement für den kapazitiven Berührungsschalter an dem Bedienfeld, durch welches das Annähern oder Auflegen eines Fingers auf die Oberseite des Bedienfeldes oberhalb der Sensorelementeinrichtung auf bekannte Art und Weise erkannt und ausgewertet werden kann, siehe beispielsweise die EP 859467 A1 und EP 859468 A1. Von dem elektrisch leitfähigen Kunststoff an der Oberseite der Sensorelementeinrichtung aus in Richtung zur Unterseite auf den Bauteilträger zu ist eine elektrische Kontaktierung vorgesehen bzw. erstreckt sich als elektrische Verbindung an den Bauteilträger und an eine Ansteuerung und/oder Auswertung. Diese elektrische Kontaktierung bzw. ein Anschluss an das kapazitive Sensorelement in Form des elektrisch leitfähigen Kunststoffs kann verschiedenartig ausgebildet sein, wie nachfolgend noch näher erläutert wird.

Mit der Erfindung kann somit eine Baueinheit geschaffen werden, welche einerseits ein Gehäuse aufweist, das ein Leuchtmittel für die Leuchtanzeige umgeben kann. An seiner Oberseite hin weist es ein Sensorelement auf für den kapazitiven Berührungsschalter, der zu der Baueinheit gehört. Des Weiteren weist die Baueinheit Befestigungsmittel auf, um vorzugsweise werkzeuglos an einem Bauteilträger befestigt zu werden. Dabei soll gleichzeitig eine elektrische Kontaktierung als elektrischer Anschluss des Sensorelements erfolgen. So ist eben die zuvor genannte schnelle und möglichst automatisierte Montage möglich, was vor allem bei Bedieneinrichtungen mit einer Vielzahl von solchen Sensorelementeinrichtungen von großem Vorteil ist.

In weiterer vorteilhafter Ausgestaltung der Erfindung kann der elektrisch leitfähige Kunststoff an der Oberseite elastisch sein, beispielsweise als Silikonkautschuk bzw. TPE. Er kann eine Härte von 30 bis 80 Shore A aufweisen, vorzugsweise 40 bis 70, insbesondere 50 bis 60. So kann er durch eine relativ geringe Andruckkraft zusammengepresst werden und gut an der Unterseite des Bedienfeldes anliegen bei gleichzeitiger Federwirkung. Dabei kann besonders vorteilhaft vorgesehen sein, dass nur der elastische elektrisch leitfähige Kunststoff an die Unterseite des Bedienfeldes angedrückt ist, nicht jedoch das sonstige Gehäuse bzw. die sonstige Baueinheit.

In weiterer vorteilhafter Ausgestaltung der Erfindung ist es möglich, dass der elektrisch leitfähige Kunststoff, insbesondere wenn er elastisch ist, die Oberseite des Gehäuses bzw. der Baueinheit ein kleines Stück überragt. Dies ist erfindungsgemäß um einen Betrag von 1 µm bis 2 mm, vorteilhaft um 50 µm bis 500 µm.

Der Überstand ist also sehr gering und sollte eben nur so sein, dass bei leichter Andruckkraft die sonstige Oberseite des Gehäuses knapp unter dem Bedienfeld verläuft.

Erfindungsgemäß ist vorgesehen, dass die elektrische Kontaktierung zur elektrischen Verbindung des genannten Sensorelements an den Bauteilträger im unteren Bereich der Baueinheit auch einen elektrisch leitfähigen Kunststoff aufweist, der wiederum besonders vorteilhaft elastisch ist mit den zuvor genannten Eigenschaften. Es kann vorzugsweise derselbe Kunststoff sein. Eine elektrische Kontaktierung zu dem elektrisch leitfähigen Kunststoff an der Oberseite als Sensorelement weist erfindungsgemäß ebenfalls einen elektrisch leitfähigen Kunststoff auf, der als vollständig durchgängige Schicht an der Außenseite des Gehäuses bzw. der Baueinheit aufgebracht ist. In einer besonders vorteilhaften Ausgestaltung der Erfindung ist es in allen drei Fällen derselbe elektrisch leitfähige Kunststoff, der also sowohl an der Oberseite als Sensorelement vorgesehen ist als auch an der Unterseite als elektrische Kontaktierung an ein Kontaktfeld oder einen Kontaktstift auf dem Bauteilträger sowie als elektrische Verbindung zwischen den beiden Bereichen. Vorteilhaft wird er auch in einem einzigen Schritt durch einen entsprechenden Spritzvorgang aufgebracht. Die elektrische Kontaktierung an der Unterseite zum Bauteilträger hin kann relativ klein sein, insbesondere Abmessungen von 1 mm bis 5 mm in Länge oder Breite aufweisen. Die elektrische Verbindung dazwischen kann ähnlich groß sein, kann aber auch vollständig umlaufend sein.

Der elektrisch leitfähige Kunststoff an der Oberseite läuft bei dem mehreckigen Querschnitt des Gehäuses bzw. der Baueinheit, vorzugsweise ein viereckiger bzw. rechteckiger Querschnitt, an mindestens drei Seiten entlang, so dass das davon gebildete kapazitive Sensorelement größer wird bzw. empfindlicher und wirksamer. Vorteilhaft läuft es an vier Seiten um bzw. ist ganz umlaufend ausgebildet, also als eine Art Rahmen. Die Größe sollte dabei in etwa so sein, dass ein Auflegen eines Fingers an der Oberseite des Bedienfeldes gut erkannt werden kann, also beispielsweise von 5 x 5 mm bis 15 x 15 mm.

In vorteilhafter Ausgestaltung der Erfindung kann bei der vorgenannten Ausbildung mit Kunststoff an der Unterseite zur elektrischen Kontaktierung dieser eine Art zumindest teilweise, vorzugsweise ganz, umlaufenden Absatz bilden. Mit diesem Absatz kann die Baueinheit gegen Kontaktierungen auf dem Bauteilträger gedrückt werden als Anschluss.

In weiterer Ausgestaltung der Erfindung kann vorgesehen sein, dass die seitliche Außenseite der Baueinheit zumindest dort, wo eine elektrische Kontaktierung oder elektrisch leitfähiges Material vorgesehen ist, bedeckt ist, vorzugsweise mit Kunststoff überspritzt bzw. umspritzt ist. Dieser Kunststoff kann von der Art sein, wie er für das Gehäuse samt Befestigungsmitteln verwendet wird, also vorteilhaft auch elektrisch isolierend. Dieser Spritzvorgang sollte im selben Mehrkomponentenspritzen stattfinden wie zur Herstellung des Gehäuses samt Befestigungsmitteln und Anspritzen des elektrisch leitfähigen Kunststoffs. Dann kann eine solche Sensorelementeinrichtung möglichst weitgehend automatisiert und somit präzise, fehlerfrei und kostengünstig hergestellt werden.

Auch der elektrisch leitfähige Kunststoff wird erfindungsgemäß an das Gehäuse bzw. an die Baueinheit angespritzt, zumindest der an der Oberseite und/oder der an der Unterseite. Auch hier kann ein Mehrkomponentenspritzen vorteilhaft sein, insbesondere als 3K-Spritzen.

In weiterer Ausgestaltung der Erfindung ist es möglich, auch die Oberseite des Gehäuses bzw. der Baueinheit elektrisch leitfähig auszubilden. Dadurch kann die Fläche des kapazitiven Sensorelements nochmals vergrößert werden, wobei dann die elektrisch leitfähige Oberseite natürlich mit dem seitlichen elektrisch leitfähigen Kunststoff oder metallischen Bauteil verbunden ist. Vorteilhaft ist dies zumindest in einem rahmenartig umlaufenden Bereich innerhalb der Außenkante des Gehäuses bzw. der Baueinheit vorgesehen, wobei ein Rahmen eine Breite von 1 mm bis 4 mm aufweisen kann. In einem freien Zwischenbereich kann das Leuchtmittel durchstrahlen. Ist das elektrisch leitfähige Material auf der Oberseite des Gehäuses, also über dem Leuchtmittel, lichtdurchlässig, so kann es auch vollflächig vorgesehen sein.

In einer etwas anderen Ausgestaltung der Erfindung kann die Oberseite des Gehäuses bzw. der Baueinheit mit einer lichtundurchlässigen elektrisch leitfähigen Schicht bedeckt sein. Diese ist wiederum an den außen umgebenden elektrischen leitfähigen Kunststoff kontaktiert, so dass wiederum ein erheblich größeres flächiges kapazitives Sensorelement entsteht. Da das Material lichtundurchlässig ist, muss es zumindest bereichsweise entfernt sein, damit das Leuchtmittel hindurchstrahlen kann. Hierbei ist es in Erweiterung der Erfindung sogar möglich, dass die lichtundurchlässige Schicht genau derart bereichsweise entfernt wird, dass ein Symbol freigelegt wird für eine Symbolanzeige als Leuchtanzeige. So braucht man keine sonstige Maskierungen odgl.. Ein Entfernen der Schicht für das Symbol kann beispielsweise mittels Laser stattfinden. Die lichtundurchlässige, elektrisch leitfähige Schicht kann ebenfalls eine Kunststoffschicht sein, die im selben Mehrkomponentenspritzen aufgebracht wird wie zuvor genannt. Alternativ kann sie später aufgebracht werden. Möglich ist auch die Verwendung eines entsprechenden Lackes, der dann strukturiert werden kann.

In weiterer Ausgestaltung der Erfindung ist es möglich, dass das Gehäuse bzw. die Baueinheit an seiner Oberseite bzw. zur Oberseite hin einen Lichtleitkörper aufweist, der über dem Leuchtmittel verläuft. Das Gehäuse kann also nicht nur das Leuchtmittel ringartig umgeben, sondern auch den Lichtleitkörper, zumindest in einem unteren Bereich. Der Lichtleitkörper kann dabei auch eine Art Diffusor bilden für das Licht, um eine gleichmäßig ausgeleuchtete Symbolanzeige oder Leuchtanzeige zu schaffen. Des Weiteren kann er, insbesondere auch durch Ausgestaltung an seiner unteren Seite als Lichteintrittsseite, entsprechende Lichtsammeleigenschaften aufweisen. Er kann auch in einem Mehrkomponentenspritzvorgang, wie eingangs genannt, zusammen mit dem Gehäuse hergestellt werden und integraler Bestandteil der Baueinheit sein. Der Lichtleitkörper kann einen Außenrand der Baueinheit bilden, insbesondere zur Oberseite hin, so dass der elektrisch leitfähige Kunststoff für das Sensorelement außen an dem Lichtleitkörper angebracht ist.

In nochmals weiterer Ausgestaltung der Erfindung kann das Gehäuse an seiner Oberseite bzw. zur Oberseite hin einen Lichtstreukörper aufweisen über dem Leuchtmittel. Vorteilhaft ist der Lichtstreukörper als sogenannte Streuscheibe ausgebildet und sorgt ebenfalls für eine gleichmäßige Lichterscheinung entsprechend der vorgenannten Diffusoreigenschaften. Durch einen vorgenannten Lichtleitkörper oder auch den genannten Lichtstreukörper mit entsprechenden Eigenschaften kann eine farbige Leuchtanzeige geschaffen werden. Ebenso können sie durch Maskierung oder entsprechende Ausgestaltung eine Symbolanzeige bilden.

Die Befestigungsmittel können mindestens ein nach unten abstehendes Befestigungsglied aufweisen, welches in eine entsprechend ausgebildete Ausnehmung in dem Bauteilträger eingesteckt werden kann. Vorteilhaft sind dies zwei Befestigungsglieder für eine sichere und verdrehfreie Befestigung. Die Befestigungsglieder können besonders vorteilhaft unterschiedliche Querschnitte in Einsteckrichtung bzw. Längsrichtung aufweisen, so dass eine Verwechslung der Einsteckposition vermieden wird. Schließlich kann ein Befestigungsglied zum selbsthalternden Einstecken ausgebildet sein, beispielsweise durch Klemmung aufgrund größerer Querschnitte oder durch Widerhaken oder Rasthaken, so dass sonstige Befestigungen wie Kleben odgl. entfallen können.

Eine eingangs genannte Bedieneinrichtung weist den Bauteilträger auf, auf dem mindestens eine vorbeschriebene Sensorelementeinrichtung angeordnet ist und/oder befestigt ist. Des Weiteren ist die Sensorelementeinrichtung an dem Bauteilträger auch elektrisch kontaktiert, insbesondere als Anschluss des kapazitiven Sensorelements sowie des Leuchtmittels. Die Bedieneinrichtung weist auch ein vorgenanntes Bedienfeld auf, an dessen Unterseite die Sensorelementeinrichtung anliegt. Durch Auflegen eines Fingers auf das Bedienfeld kann eine entsprechende Steuerung erfolgen, wie dies dem Fachmann aus dem vorgenannten Stand der Technik bekannt ist.

In besonders vorteilhafter Ausgestaltung der Erfindung ist die Bedieneinrichtung für ein Kochfeld vorgesehen, so dass das Bedienfeld eine Kochfeldplatte des Kochfeldes sein kann. Dabei können eben mehrere Sensorelementeinrichtungen auf einem Bauteilträger unter der Kochfeldplatte vorgesehen sein und verschiedene Schaltfunktionen ermöglichen.

Der Rahmen der Erfindung wird durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine seitliche Schnittdarstellung einer erfindungsgemäßen Anordnung mit einer Sensorelementeinrichtung mit mehrteiligem Gehäuse,
- Fig. 2: eine Draufsicht auf die Sensorelementeinrichtung aus Fig. 1,
- Fig. 3: eine Schnittdarstellung durch eine Bedieneinrichtung eines Kochfeldes mit der Sensorelementeinrichtung aus Fig. 1 auf einer Leiterplatte samt LED,
- Fig. 4: eine abgewandelte Ausbildung der Sensorelementeinrichtung aus Fig. 1 und
- Fig. 5: eine Draufsicht auf die Sensorelementeinrichtung aus Fig. 4.

### Detaillierte Beschreibung der Ausführungsbeispiele

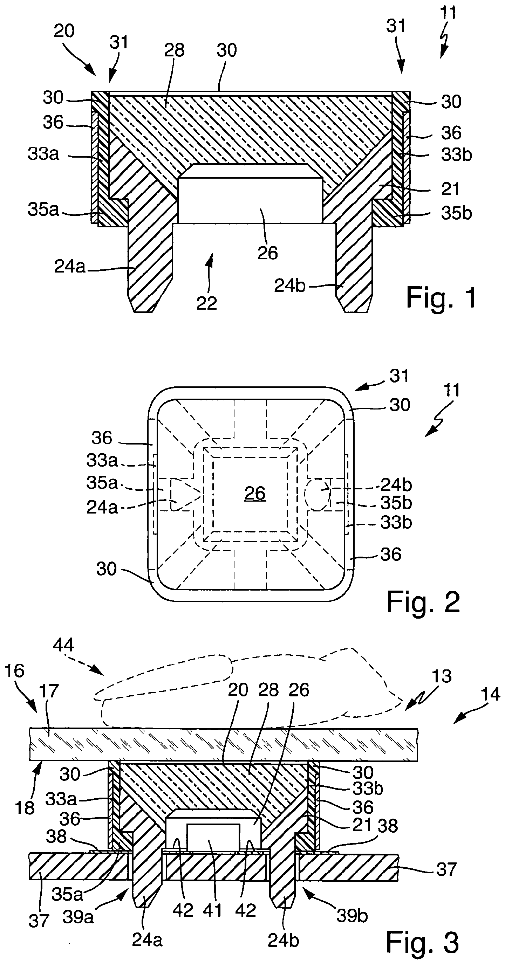

In der Fig. 1 ist im seitlichen Schnitt eine erfindungsgemäße Sensorelementeinrichtung in einer Ausführungsvariante dargestellt. Die Sensorelementeinrichtung 11 weist eine Oberseite 20 eines Gehäuses 22 auf, wobei das Gehäuse aus Kunststoff besteht wie zuvor erläutert worden ist. Unten an dem Gehäuse 22 sind links ein Befestigungsstift 24a und rechts ein etwas anders geformter Befestigungsstift 24b angeformt, deren Querschnitte aus der Draufsicht aus Fig. 2 zu ersehen sind. Das Gehäuse 22 weist hier ein Unterteil 21 auf, von dem die genannten Befestigungsstifte 24a und b abstehen, wobei das Unterteil 21 aus lichtundurchlässigem isolierendem Kunststoff besteht, der vorteilhaft allgemein unelastisch bzw. starr ist. Ein Oberteil des Gehäuses 22 wird von einem Lichtleitkörper 28 aus lichtdurchlässigem Kunststoff gebildet, wobei dieser entweder vollständig durchsichtig oder aber transluzent sein kann, so dass er beispielsweise die eingangs genannten Diffusoreigenschaften für eine gleichmäßige Leuchterscheinung aufweisen kann. Eine Ausnehmung 26 ist sowohl im Unterteil 21 als auch im Lichtleitkörper 28 des Gehäuses 22 vorgesehen, in der, wie nachfolgend noch dargestellt wird, eine LED bzw. ein Leuchtmittel angeordnet wird. Unterteil 21 und Lichtleitkörper 28 bilden zusammen das Gehäuse 22 bzw. sind Teil davon und sind vorteilhaft in einem Mehrkomponentenspritzvorgang zusammen hergestellt.

An der oberen Außenseite des Gehäuses 22 bzw. hier des Lichtleitkörpers 28 ist ein umlaufender Kragen 30 angeformt, dessen Ausgestaltung auch aus der Draufsicht aus Fig. 2 ersichtlich wird. Der Kragen 30 besteht hier aus elastischem und elektrisch leitfähigem Kunststoff, beispielsweise einem elektrisch leitfähigen Silikon, und ist vorteilhaft an das Gehäuse 22 bzw. den Lichtleitkörper 28 angespritzt. Der umlaufende Kragen 30 bildet auch gleichzeitig das eingangs genannte kapazitive Sensorelement 31. Wie zu erkennen ist, steht der Kragen 30 etwas über die Oberseite 20 über, beispielsweise 50 µm bis 100 µm.

In Zusammenschau mit der Draufsicht aus Fig. 2 ist zu ersehen, wie unten an dem Kragen 30 links und rechts außen an das Gehäuse 22 jeweils eine streifenartige elektrische Verbindungskontaktierung 33a und b angeformt ist. Sie gehen unten jeweils in einen linken und rechten elektrischen Kontaktierungsbalken 35a und b über, dessen Form wiederum aus Fig. 2 zu ersehen ist, der zwar nicht so lang ist, dafür aber deutlich breiter. Vorteilhaft sind, wie dargestellt, Kragen 30, Verbindungskontaktierung 33 und Kontaktierungsbalken 35 aus demselben Material hergestellt, besonders vorteilhaft einstückig. Somit kann das kapazitive Sensorelement 31 unten am Kontaktierungsbalken 35a und b elektrisch kontaktiert werden, was nachfolgend noch näher erläutert wird. Dabei kann der Kontaktierungsbalken 35a und 35b über die Unterseite des Unterteils 21 etwas überstehen, beispielsweise 50 µm bis 100 µm wie zuvor für die Oberseite beschrieben.

Außen ist seitlich am Gehäuse 22 ein Mantel 36 angeformt, insbesondere angespritzt, der vorteilhaft aus demselben Kunststoff wie das Unterteil 21 besteht. Der Mantel 36 kann zwar ganz umlaufend ausgebildet sein und so die Verbindungskontaktierungen 33a und 33b überdecken. Alternativ kann der Mantel 36 nur an der linken und der rechten Außenseite über den Verbindungskontaktierungen 33 vorgesehen sein.

In der Fig. 3 ist ein Einbauzustand für die Sensorelementeinrichtung 11 dargestellt, und zwar als kapazitiver Berührungsschalter 13 mit dem kapazitiven Sensorelement 31 als Bedieneinrichtung 14. Die Bedieneinrichtung 14 ist an einem Kochfeld 16 vorgesehen bzw. darin integriert, und zwar, wie eingangs beschrieben, mit einer Kochfeldplatte 17, vorteilhaft aus Hartglas oder Glaskeramik, als Bedienfeld. Oben auf die Kochfeldplatte 17 als Bedienfeld kann ein gestrichelt dargestellter Finger 44 zur Betätigung aufgelegt werden, was durch das kapazitive Sensorelement 31 samt Ansteuerung auf übliche Art und Weise erkannt werden kann.

Es ist zu erkennen, dass die Sensorelementeinrichtung 11 an eine Unterseite 18 der Kochfeldplatte 17 angedrückt ist und dabei der Kunststoffkragen 30 des kapazitiven Sensorelements 31 etwas zusammengedrückt ist. Die Oberseite 20 des Gehäuses 22 bzw. des Lichtleitkörpers 28 kann dabei einen geringen Abstand zur Unterseite 18 aufweisen, beispielsweise 10 µm bis 100 µm. Alternativ kann sie auch direkt berühren, je nach gewählter Anpresskraft.

Die Sensorelementeinrichtung 11 ist mit den Befestigungsstiften 24a und 24b in Löcher 39a und 39b einer Leiterplatte 37 als Bauteilträger eingedrückt. Die Befestigungslöcher 39 sind dabei so ausgebildet, dass dieses Eindrücken kraftschlüssig und klemmend erfolgt, so dass eine weitere Befestigung entfallen kann. Auf der Oberseite der Leiterplatte 37 befinden sich außerhalb der Befestigungslöcher 39 zwei Kontaktierungsfelder 38, vorteilhaft als übliche Kupferflächen. Innerhalb der Befestigungslöcher 39 befinden sich zwei Kontaktfelder 42. Auf die Kontaktierungsfelder 38 sind die Kontaktierungsbalken 35a und b der Sensorelementeinrichtung 11 aufgedrückt und stellen so den elektrischen Kontakt an das kapazitive Sensorelement 31 dar, also mittels der Verbindungskontaktierungen 33a und b links und rechts. Elektrische Kontakte können unter Umständen noch durch das Vorsehen von Leitkleber oder Leitpaste verbessert werden, was aber nicht unbedingt notwendig ist.

Auf die Kontaktfelder 42 ist eine LED 41 als SMD-Bauteil aufgebracht, insbesondere festgelötet, was vor dem Aufsetzen der Sensorelementeinrichtung 11 erfolgt ist. Somit wird die LED 41 vor der Sensorelementeinrichtung 11 montiert.

Bei der hier beschriebenen Ausgestaltung ist in erster Linie vorgesehen, dass das kapazitive Sensorelement 31 nur von dem gemäß Fig. 2 ganz umlaufenden Kragen 30 aus Kunststoff gebildet wird. Weist dieser Kragen 30 eine Seitenlänge von den eingangs genannten 5 mm bis 15 mm auf, so kann mit einem solchen kapazitiven Sensorelement 31 ausreichend gut das Auflegen des Fingers 44 gemäß Fig. 3 oberhalb davon erkannt werden. Eine zusätzliche Verbesserung der Erfassung einer Betätigung kann dadurch erfolgen, dass die Oberseite 20 des Lichtleitkörpers 28 mit einer durchsichtigen und elektrisch leitfähigen Schicht bedeckt ist, beispielsweise einem durchsichtigen Leitlack oder einer Schicht aus transparentem Zinnoxid. Dann wird das kapazitive Sensorelement von der gesamten Fläche der Oberseite samt umlaufendem Kragen 30 gebildet. Alternativ ist es möglich, wie eingangs erläutert, eine solche elektrisch leitfähige Beschichtung der Oberseite 20 zwar elektrisch leitfähig aber lichtundurchlässig auszubilden und dabei entweder ein Symbol oder eine gewünschte Leuchtanzeige frei zu lassen oder nachträglich herauszuarbeiten, beispielsweise durch mechanische oder Laser-Bearbeitung. Damit kann also einerseits eine gewünschte Symbolanzeige leicht erzeugt werden, andererseits kann die Genauigkeit der Erfassung verbessert werden und eine einfachere Möglichkeit für eine elektrisch leitfähige Schicht auf der Oberseite 20 geschaffen werden. In nochmals weiterer Ausgestaltung der Erfindung kann eine elektrisch leitfähige Schicht als wenige Millimeter breiter Rahmen innerhalb des Kragens 30 verlaufen, der dann in der Mitte ein Feld beispielsweise entsprechend der Ausnehmung 26 freilässt.

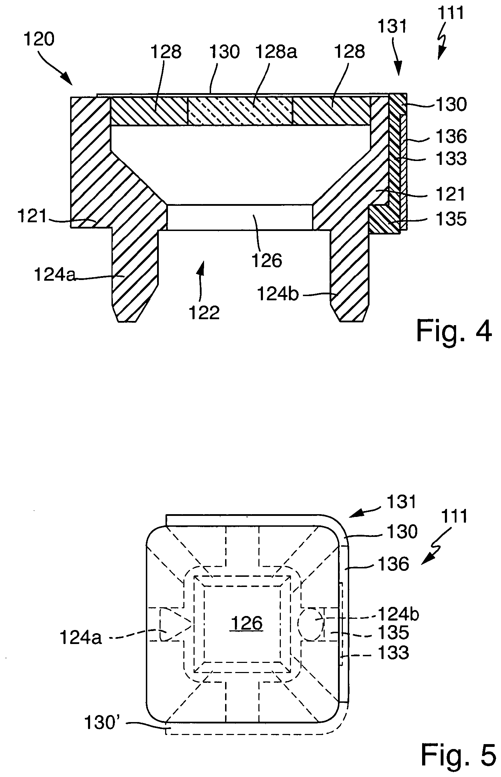

In der Fig. 4 ist eine weitere Abwandlung der Erfindung dargestellt bei einer Sensorelementeinrichtung 111, die genauso eingebaut wird wie diejenige der Fig. 3. Ein Gehäuse 122 besteht in der dargestellten Form nur aus dem Unterteil 121, an welches unten die Befestigungsstifte 124a und b in der Form gemäß den Fig. 1 und 2 angeformt sind, wobei das Unterteil 121 aus lichtundurchlässigem Kunststoff besteht. Nur an der rechten Seite ist an einen Kragen 130 aus elektrisch leitfähigem Kunststoff eine elektrische Verbindungskontaktierung 133 samt elektrischem Kontaktierungsbalken 135 angeformt gemäß Fig. 1. Der Kragen 130 überragt die Oberseite 120 wieder ein kleines Stück wie zuvor erläutert. Nochmals außen daran ist bereichsweise eine Überdeckung 136 aus demselben Kunststoff wie das Unterteil 121 angespritzt.

Oberhalb einer Ausnehmung 126 im Gehäuse 122 ist hier kein Lichtleitkörper, sondern eine Streuscheibe 128 eingesetzt, die viel dünner ist. Sie besteht aus lichtundurchlässigem Material und weist in der Mitte einen Symbolbereich 128a aus transparentem oder transluzentem Material auf, wie es zuvor beschrieben worden ist. Der Symbolbereich 128 kann eine bestimmte Symbolform aufweisen, beispielsweise als Plus- oder sonstiges Zeichen. Die Streuscheibe 128 kann einstückig durch Mehrkomponentenspritzen hergestellt und dann nachträglich in das Gehäuse 122 bzw. in das Unterteil 121 eingepasst sein. Alternativ kann sie auch zusammen mit diesem hergestellt sein, wobei dann beispielsweise der den Symbolbereich 128a umgebende Kunststoff zusammen mit demjenigen des Unterteils 121 hergestellt werden kann, also einteilig und einstückig. Die Leuchtanzeige wird somit durch die LED 141 als Leuchtmittel samt Lichtleitkörper 28 oder Streuscheibe 128 samt Symbolbereich 128a gebildet und ist durch die transluzente Kochfeldplatte 17 hindurch sichtbar.

In der Draufsicht aus Fig. 5 ist zu ersehen, dass der Kragen 130 nur an der dort dargestellten oberen Seite und der rechten Seite vorgesehen ist, also quasi nur als eine Art Winkel und somit nicht umlaufend entsprechend Fig. 2. Auch dies kann bereits für die Funktion des kapazitiven Sensorelements 131 ausreichen. Zusätzlich kann noch, wie gestrichelt dargestellt, ein unterer Kragenteil 130' vorgesehen sein, so dass insgesamt der Kragen 130 eine U-Form aufweist. Auch hier kann an der Oberseite 120 wiederum, wie bereits zuvor zur Fig. 3 allgemein erläutert worden ist, auf der Oberseite 120 elektrisch leitfähiges Material als Schicht vorgesehen sein, welches an den Kragen 130 elektrisch verbunden ist und somit die Fläche des kapazitiven Sensorelements 131 vergrößert.

In hier nicht dargestellter, aber leicht vorstellbarer jedoch nicht zur Erfindung gehörender Variation der Erfindung kann anstelle des Kragens aus Kunststoff 30 bzw. 130 auch ein solcher Kragen bzw. ein umlaufendes Teil aus Metall vorgesehen sein, beispielsweise als Metallrahmen odgl.. Ähnliches kann auch für den unteren Kontaktierungsbalken 35 bzw. 135 gelten. Derartige Metallteile können dann in das Gehäuse eingespritzt sein.

Des Weiteren ist es möglich, eine Verbindungskontaktierung 33 bzw. 133 nicht aus einem angespritzten elektrisch leitfähigen Kunststoff auszubilden, sondern aus Leitlack. Alternativ kann auch dieses ein Metallteil sein, an welches oben und unten als Kragen und Kontaktierungsbalken elektrisch leitfähiger Kunststoff angespritzt wird und die Kontaktierung durch Berührung und Überlappen erfolgt.

Mit der Erfindung kann eine Sensorelementeinrichtung geschaffen werden, die über einem einfach ausgebildeten Leuchtmittel, beispielsweise als LED, einen kapazitiven Berührungsschalter schafft, so dass eine Bedienperson lediglich den Finger über ein beleuchtetes Symbol oder eine Leuchtanzeige legen muss. Des Weiteren kann durch die beschriebenen verschiedenen Ausgestaltungen der Sensorelementeinrichtung der Leuchtanzeige eine bestimmte Symbol- oder sonstige Form erreicht werden. Es werden also eine Symbolanzeige und ein kapazitiver Berührungsschalter in ein einziges Bauteil bzw. eine einzige Baueinheit integriert. Durch das einfache Andrücken zur Montage der Sensorelementeinrichtung als elektrische Kontaktierung können aufwendige Kontaktierungsschritte wie Löten odgl. entfallen, und mit dem Aufdrücken der Sensorelementeinrichtung auf eine Leiterplatte über einer vormontierten LED ist die Montage schon abgeschlossen. Des Weiteren kann die Sensorelementeinrichtung leicht oder mit Druck an die Unterseite einer Kochfeldplatte oder eines sonstigen Bedienfeldes angelegt werden. Je nach Anpresskraft und Ausgestaltung des kapazitiven Sensorelements kann eine gewisse elastische Wirkung erreicht werden, und auch die Oberseite eines Lichtleitkörpers oder einer Streuscheibe kann sehr nahe an der Unterseite sein für eine gute Erkennbarkeit der Leuchtanzeige.

In weiterer Ausgestaltung der Erfindung kann auch mindestens einer der Befestigungsstifte elektrisch leitfähig ausgebildet sein, entweder aus elektrisch leitfähigem Kunststoff oder durch eine elektrisch leitfähige Beschichtung. Er kann dann beispielsweise durch Einstecken in ein innen verkupfertes Befestigungsloch in einer Leiterplatte die elektrische Kontaktierung herstellen, wobei eine entsprechende Leiterbahn auf der Leiterplatte an der Oberseite oder der Unterseite vorgesehen sein kann.

## Patentansprüche

1. Anordnung mit einer Sensorelementeinrichtung an einem Bauteilträger (37) für einen kapazitiven Berührungsschalter (13) einer Bedieneinrichtung (14), wobei die Sensorelementeinrichtung (11, 111) eine Oberseite (20, 120), die zur Unterseite (18) eines Bedienfeldes (17) der Bedieneinrichtung (14) hin gerichtet ist und eine Leuchtanzeige mit einem Leuchtmittel (41) mit Leuchtrichtung zur Unterseite des Bedienfeldes (17) hin aufweist, wobei um das Leuchtmittel (41) herum ein Gehäuse (22, 122) vorgesehen ist und das Gehäuse mit Befestigungsmitteln (24, 124) zur Befestigung der Sensorelementeinrichtung (11, 111) an dem Bauteilträger (37) zusammen eine Baueinheit bildet, die einen mehreckigen Querschnitt aufweist, wobei außen an der Baueinheit zumindest in dem Bereich zur Oberseite (20, 120) hin ein kapazitives Sensorelement vorgesehen ist aus elektrisch leitfähigem Kunststoff (30, 130), der an mindestens drei Seiten an der Oberseite (20, 120) als Kragen entlang eines Außenrandes der Baueinheit verläuft, wobei sich von dem kapazitiven Sensorelement aus in Richtung zur Unterseite auf den Bauteilträger (37) zu eine Kontaktierung (33, 133) aus elektrisch leitfähigem Kunststoff (35, 135) erstreckt zur elektrischen Verbindung an den Bauteilträger, wobei
- der Kragen die Oberseite (20, 120) der Baueinheit um 1 µm bis 2 mm überragt, und
- der elektrisch leitfähige Kunststoff (30, 33, 35, 130, 133, 135) des kapazitiven Sensorelements (30, 130) und der Kontaktierung (33, 35, 133, 135) an die Baueinheit angespritzt ist.

2. Anordnung nach Anspruch 1, **dadurch gekennzeichnet, dass** der elektrisch leitfähige Kunststoff (30, 130) elastisch ist.

3. Anordnung nach einem der vorhergehenden Ansprüche, **dadurch gekennzeichnet, dass** der elektrisch leitfähige Kunststoff (30, 130) an der Oberseite als durchgängige Schicht an die Außenseite aufgebracht ist.

4. Anordnung nach einem der vorhergehenden Ansprüche, **dadurch gekennzeichnet, dass** der elektrisch leitfähige Kunststoff (30, 130) an der Oberseite (20, 120) an vier Seiten bzw. ganz umlaufend ausgebildet ist.

5. Anordnung nach einem der vorhergehenden Ansprüche, **dadurch gekennzeichnet, dass** an der seitlichen Außenseite der Baueinheit der elektrisch leitfähige Kunststoff (33, 133) weitgehend, insbesondere in Ringform, umspritzt ist mit Kunststoff (36, 136), insbesondere mit einem Kunststoff, wie er auch für das Gehäuse (22, 122) samt Befestigungsmitteln (24, 124) verwendet wird, vorzugsweise im selben Vorgang wie zur Herstellung des Gehäuses (22, 122) samt Befestigungsmitteln (24, 124).

6. Anordnung nach einem der vorhergehenden Ansprüche, **dadurch gekennzeichnet, dass** die Oberseite (20, 120) der Baueinheit ebenfalls elektrisch leitfähig ausgebildet ist, vorzugsweise zumindest in einem rahmenartig umlaufenden Bereich innerhalb der Außenkante des Gehäuses (22, 122).

7. Anordnung nach einem der vorhergehenden Ansprüche, **dadurch gekennzeichnet, dass** die Oberseite (20, 120) der Baueinheit mit einer lichtundurchlässigen, elektrisch leitfähigen Schicht bedeckt ist, die an den außen umgebenden elektrisch leitfähigen Kunststoff (30, 130) kontaktiert ist, wobei durch bereichsweises Entfernen der Schicht ein Symbol für eine Symbolanzeige der Leuchtanzeige hergestellt ist, insbesondere durch Entfernen mittels Laser.

8. Anordnung nach einem der vorhergehenden Ansprüche, **dadurch gekennzeichnet, dass** das Gehäuse (22) an seiner Oberseite (20) bzw. zu seiner Oberseite (20) hin einen Lichtleitkörper (28) aufweist, der über dem Leuchtmittel (41) verläuft, wobei vorzugsweise das Gehäuse (22) den Lichtleitkörper (28) ringartig umgibt zumindest in einem unteren Bereich.

9. Anordnung nach einem der vorhergehenden Ansprüche, **dadurch gekennzeichnet, dass** das Gehäuse (122) an seiner Oberseite (120) bzw. zu seiner Oberseite (120) hin einen Lichtstreukörper (128) aufweist, der über dem Leuchtmittel (41) verläuft.

10. Anordnung nach einem der vorhergehenden Ansprüche, **dadurch gekennzeichnet, dass** die Befestigungsmittel mindestens ein nach unten abstehendes Befestigungsglied (24, 124) zum Einstecken in eine Ausnehmung (39) in dem Bauteilträger (37) aufweisen, vorzugsweise zwei Befestigungsglieder (24a, 24b, 124a, 124b), die insbesondere unterschiedliche Querschnitte in Einsteckrichtung aufweisen und zum selbsthalternden Einstecken ausgebildet sind.

11. Bedieneinrichtung mit mindestens einer Anordnung nach einem der vorhergehenden Ansprüche, **dadurch gekennzeichnet, dass** zusätzlich zu der Sensorelementeinrichtung (11, 111) und dem Bauteilträger (37) auch ein Bedienfeld (17) vorgesehen ist, an dessen Unterseite (18) die Sensorelementeinrichtung (11) anliegt.

12. Bedieneinrichtung nach Anspruch 11, **dadurch gekennzeichnet, dass** das Bedienfeld als Kochfeldplatte (17) für ein Kochfeld (16) ausgebildet ist.

13. Kochfeld (16) mit einer Bedieneinrichtung nach Anspruch 11 oder 12, wobei es mehrere Anordnungen nach einem der Ansprüche 1 bis 10 für die Bedieneinrichtung (14) aufweist.

## Claims

1. Arrangement with a sensor element device on a component carrier (37) for a capacitive touch switch (13) of an operating device (14), the sensor element device (11, 111) having an upper side (20, 120) oriented toward the underside (18) of a control panel (17) of the operating device (14) and having an illuminated display with a lighting means (41) with a lighting direction toward the underside of the control panel (17), wherein a housing (22, 122) is provided around the lighting means (41) and the housing together with fastening means (24, 124) for fastening the sensor element device (11, 111) to the component carrier (37) forms a structural unit having a polygonal cross section, wherein on the outside of the structural unit, at least in the region toward the upper side (20, 120), a capacitive sensor element composed of electrically conductive plastic (30, 130) is provided and extending on at least three sides on the upper side (20, 120) as a collar along an outer periphery of the structural unit, wherein from the capacitive sensor element in the direction toward the underside toward the component carrier (37) a contacting means (33, 133) composed of electrically conductive plastic (35, 135) extends for electrical connection to the component carrier, wherein the collar protrudes beyond the upper side (20, 120) of the structural unit by an amount of 1 µm to 2 mm, and the electrically conductive plastic (30, 33, 35, 130, 133, 135) of the capacitive sensor element (30, 130) and the contacting means (33, 35, 133, 135) is injection-molded onto the structural unit.

2. Arrangement according to claim 1, **characterized in that** the electrically conductive plastic (30, 130) is elastic.

3. Arrangement according to one of the preceding claims, **characterized in that** the electrically conductive plastic (30, 130) on the upper side is applied as a continuous layer to the outer side.

4. Arrangement according to one of the preceding claims, **characterized in that** the electrically conductive plastic (30, 130) on the upper side (20, 120) is formed on four sides or so as to extend completely around the periphery.

5. Arrangement according to one of the preceding claims, **characterized in that**, on the lateral outer side of the structural unit, the electrically conductive plastic (33, 133) is largely encapsulated, in particular in the form of a ring, with plastic (36, 136), in particular with a plastic such as that which is also used for the housing (22, 122) together with the fastening means (24, 124), preferably in the same operation as for producing the housing (22, 122) together with the fastening means (24, 124).

6. Arrangement according to one of the preceding claims, **characterized in that** the upper side (20, 120) of the structural unit is likewise formed to be electrically conductive, preferably at least in a region extending peripherally in the manner of a frame within the outer edge of the housing (22, 122).

7. Arrangement according to one of the preceding claims, **characterized in that** the upper side (20, 120) of the structural unit is covered with an opaque, electrically conductive layer which is in electrical contact with the externally surrounding electrically conductive plastic (30, 130), wherein a symbol for a symbol display of the illuminated display is produced by removal of the layer in certain regions, in particular by removal by means of a laser.

8. Arrangement according to one of the preceding claims, **characterized in that** the housing (22) has on its upper side (20) or toward its upper side (20) a light-conducting body (28) which extends over the lighting means (41), wherein the housing (22) preferably surrounds the light-conducting body (28) in the manner of a ring, at least in a lower region.

9. Arrangement according to one of the preceding claims, **characterized in that** the housing (122) has on its upper side (120) or toward its upper side (120) a light-diffusing body (128) which extends over the lighting means (41).

10. Arrangement according to one of the preceding claims, **characterized in that** the fastening means have at least one downwardly protruding fastening element (24, 124) for inserting into a clearance (39) in the component carrier (37), preferably two fastening elements (24a, 24b, 124a, 124b), which have in particular different cross sections in the direction of insertion and are designed for self-securing insertion.

11. Operating device with at least one arrangement according to one of the preceding claims, **characterized in that** in addition to the sensor element device (11, 111) and the component carrier (37) also a control panel (17) is provided, against the underside of which the sensor element device (11) is placed.

12. Operating device according to claim 11, **characterized in that** the control panel is designed as a hob panel (17) for a hob (16).

13. Hob (16) with an operating device as claimed in claim 11 or 12, wherein it has a number of arrangements according to one of claims 1 to 10 for the operating device (14).

## Revendications

1. Dispositif comportant un équipement d'éléments de capteurs sur un support de composants (37) destiné à un commutateur tactile capacitif (13) d'un équipement de commande (14), dans lequel l'équipement d'éléments de capteurs (11, 111) comprend une face supérieure (20, 120) dirigée vers la face inférieure (18) d'un panneau de commande (17) de l'équipement de commande (14) et comportant un affichage lumineux doté d'un moyen d'éclairage (41) ayant une direction d'éclairage orientée vers la face inférieure du panneau de commande (17), dans lequel il est prévu un boîtier (22, 122) entourant le moyen d'éclairage (41) et le boîtier forme, en association avec des moyens de fixation (24, 124) destinés à fixer l'équipement d'éléments de capteurs (11, 111) au support de composants (37), un module structurel qui présente une section transversale polygonale, dans lequel il est prévu extérieurement, sur ledit module structurel, au moins dans la zone tournée vers la face supérieure (20, 120), un élément capteur capacitif en matière plastique électriquement conductrice (30, 130), qui s'étend sous forme de collier le long d'un bord extérieur du module structurel sur au moins trois côtés et sur la face supérieure (20, 120), dans lequel un élément de contact (33, 133) en matière plastique électriquement conductrice (35, 135) s'étend depuis l'élément de capteur capacitif en direction de la face inférieure, sur le support de composant (37), pour la connexion électrique au support de composant, dans lequel le collier dépasse de 1 µm à 2 mm de la face supérieure (20, 120) du module structurel, et la matière plastique électriquement conductrice (30, 33, 35, 130, 133, 135) de l'élément de capteur capacitif (30, 130) et de l'élément de contact (33, 35, 133, 135) est appliquée par injection sur le module structurel.

2. Dispositif selon la revendication 1, **caractérisé en ce que** la matière plastique électriquement conductrice (30, 130) est élastique.

3. Dispositif selon l'une des revendications précédentes, **caractérisé en ce que** la matière plastique électriquement conductrice (30, 130) est appliquée sur la face supérieure, sous la forme d'une couche continue au niveau de la face extérieure.

4. Dispositif selon l'une des revendications précédentes, **caractérisé en ce que** la matière plastique électriquement conductrice (30, 130) est formée sur la face supérieure (20, 120) sur quatre côtés ou sur la totalité de la périphérie.

5. Dispositif selon l'une des revendications précédentes, **caractérisé en ce que** la matière plastique électriquement conductrice (33, 133) est en grande partie encapsulée, notamment sous forme annulaire, sur la face extérieure latérale du module structurel, avec une matière plastique (36, 136), notamment avec la matière plastique qui sert également au boîtier (22, 122) en association avec les moyens de fixation (24, 124), de préférence selon un processus identique à celui utilisé pour produire le boîtier (22, 122) et les moyens de fixation (24, 124).

6. Dispositif selon l'une des revendications précédentes, **caractérisé en ce que** la face supérieure (20, 120) du module structurel est également électriquement conductrice, de préférence au moins dans une zone périphérique en forme de cadre à l'intérieur du bord extérieur du boîtier (22, 122).

7. Dispositif selon l'une des revendications précédentes, **caractérisé en ce que** la face supérieure (20, 120) du module structurel est recouverte d'une couche opaque électriquement conductrice, qui est en contact avec la matière plastique électriquement conductrice (30, 130) entourant la face extérieure, dans lequel un symbole destiné à un affichage de symbole sur l'affichage lumineux est produit par enlèvement de la couche par zones, en particulier par enlèvement au moyen d'un laser.

8. Dispositif selon l'une des revendications précédentes, **caractérisé en ce que** le boîtier (22) présente respectivement sur sa face supérieure (20) ou vers sa face supérieure (20), un corps de guidage de lumière (28) qui s'étend au-dessus du moyen d'éclairage (41), dans lequel le boîtier (22) entoure de préférence de manière annulaire le corps de guidage de lumière (28), au moins dans une zone inférieure.

9. Dispositif selon l'une des revendications précédentes, **caractérisé en ce que** le boîtier (122) présente respectivement sur sa face supérieure (120) ou vers sa face supérieure (120), un corps diffusant la lumière (128) qui s'étend au-dessus des moyens d'éclairage (41).

10. Dispositif selon l'une des revendications précédentes, **caractérisé en ce que** les moyens de fixation comportent au moins un élément de fixation (24, 124) dépassant vers le bas et destiné à être inséré dans un évidement (39) ménagé dans le support de composants (37), de préférence deux éléments de fixation (24a, 24b, 124a, 124b), qui présentent notamment différentes sections transversales dans la direction d'insertion et sont conçus pour être insérés en étant auto-maintenus.

11. Équipement de commande comportant au moins un dispositif selon l'une des revendications précédentes, **caractérisé en ce qu'**il est prévu, en plus de l'équipement d'éléments de capteurs (11, 111) et du support de composants (37), un panneau de commande (17) sur la face inférieure (18) duquel repose l'équipement d'éléments de capteurs (11).

12. Équipement de commande selon la revendication 11, **caractérisé en ce que** le panneau de commande est réalisé sous la forme d'une plaque de cuisson (17) pour une table de cuisson (16).

13. Table de cuisson (16) comportant un équipement de commande selon la revendication 11 ou 12, **caractérisée en ce qu'**elle comporte plusieurs dispositifs selon l'une des revendications 1 à 10 destinés à l'équipement de commande (14).
